# EUROPÄISCHE PATENTSCHRIFT

(11) **EP 2 583 319 B1**
(45) Veröffentlichungstag und Bekanntmachung des Hinweises auf die Patenterteilung: **07.08.2019**
(21) Anmeldenummer: 11720815.7
(22) Anmeldetag: 24.05.2011
(51) Int. Cl.: H01L 33/62, H01L 33/60, H01L 33/44, H01L 33/48

(54) **OPTOELEKTRONISCHES BAUTEIL**
OPTOELECTRONIC COMPONENT
COMPOSANT OPTOÉLECTRONIQUE

(30) Priorität: 16.06.2010 DE 102010023955
(43) Veröffentlichungstag der Anmeldung: 24.04.2013
(73) Patentinhaber: OSRAM Opto Semiconductors GmbH, 93055 Regensburg (DE)
(72) Erfinder: O'BRIEN, David, 93077 Bad Abbach (DE); HAUSHALTER, Martin, 93055 Regensburg (DE); FOERSTE, Markus, 85579 Neubiberg (DE); MÖLLMER, Frank, 93080 Matting b. Pentling (DE)
(74) Vertreter: Zacco Patent- & Rechtsanwälte
(86) Internationale Anmeldenummer: PCT/EP2011/058489
(87) Internationale Veröffentlichungsnummer: WO 2011/157515

(56) Entgegenhaltungen:
- EP-A1- 2 583 319
- WO-A1-2007/015426
- WO-A1-2009/066206
- WO-A1-2010/035206
- WO-A2-2009/075530
- DE-A1- 10 117 890
- JP-A- H0 832 118
- US-A1- 2004 036 078
- US-A1- 2006 102 917
- US-A1- 2006 285 804
- US-A1- 2008 185 605
- US-A1- 2008 265 266
- US-A1- 2009 224 271
- US-A1- 2010 078 669
- US-A1- 2010 127 300

## Beschreibung

Es wird ein optoelektronisches Bauteil angegeben.

Die Druckschriften WO 2004/077558 A1, US 2008/0185605A1 und US2010/127300A1 beschreiben optoelektronische Bauteile.

Die Druckschrift JP H08 32118 A beschreibt eine Leuchtdiode mit einem reflektierenden Gehäusekörper.

Eine zu lösende Aufgabe besteht darin, ein optoelektronisches Bauteil anzugeben, das besonders kompakt ist.

Die Erfindung betrifft ein optoelektronisches Bauteil gemäß Anspruch 1.

Gemäß zumindest einer Ausführungsform des optoelektronischen Bauteils umfasst das optoelektronische Bauteil eine Leiterplatte. Die Leiterplatte umfasst beispielsweise einen Grundkörper, der mit einem elektrisch isolierenden Material gebildet ist. Auf und/oder in den Grundkörper sind Leiterbahnen und elektrische Anschlussstellen strukturiert, die zur elektrischen Kontaktierung von auf die Leiterplatte aufgebrachten Komponenten des optoelektronischen Bauteils dienen.

Die Leiterplatte umfasst beispielsweise einen Grundkörper, der mit einem Kunststoffmaterial gebildet ist. Der Grundkörper kann dabei aus dem Kunststoffmaterial bestehen. Bei der Leiterplatte handelt es sich um eine bedruckte Leiterplatte (PCB - Printed Circuit Board).

Die Leiterplatte umfasst eine Oberseite, die beispielsweise durch eine erste Hauptfläche der Leiterplatte gebildet ist. Ferner umfasst die Leiterplatte eine Unterseite, die der Oberseite abgewandt ist. An ihrer Oberseite weist die Leiterplatte einen Chipanschlussbereich auf. Bei dem Chipanschlussbereich handelt es sich beispielsweise um einen metallisierten Bereich der Leiterplatte, an dem beispielsweise ein optoelektronischer Halbleiterchip befestigt und elektrisch leitend angeschlossen werden kann. Die Leiterplatte kann dabei auch zwei oder mehr gleichartig ausgebildete Chipanschlussbereiche an ihrer Oberseite aufweisen.

Das optoelektronische Bauteil umfasst einen optoelektronischen Halbleiterchip, der am Chipanschlussbereich befestigt ist. Der optoelektronische Halbleiterchip kann beispielsweise am Chipanschlussbereich angelötet oder aufgeklebt sein. Bei dem optoelektronischen Halbleiterchip handelt es sich um einen strahlungsempfangenden oder um einen strahlungsaussendenden optoelektronischen Halbleiterchip. Beispielsweise handelt es sich bei dem optoelektronischen Halbleiterchip um einen Leuchtdiodenchip, der im Betrieb zur Erzeugung von elektromagnetischer Strahlung aus dem Infrarotbereich, dem Spektralbereich für sichtbares Licht und/oder dem Spektralbereich von UV-Strahlung geeignet ist. Das Bauteil kann auch zwei oder mehr optoelektronische Halbleiterchips umfassen, wobei jeder optoelektronische Halbleiterchip an einem Chipanschlussbereich befestigt ist.

Bevorzugt handelt es sich bei dem optoelektronischen Halbleiterchip um einen Oberflächenstrahler. Das heißt der optoelektronische Halbleiterchip gibt die emittierte elektromagnetische Strahlung größtenteils oder vollständig durch eine Hauptfläche, zum Beispiel an der Oberseite des optoelektronischen Halbleiterchips ab. Durch die Seitenflächen des optoelektronischen Halbleiterchips wird dann kaum oder gar keine elektromagnetische Strahlung emittiert. Der optoelektronische Halbleiterchip ist dazu vorzugsweise als Dünnfilm-Leuchtdiodenchip ausgeführt.

Ein Dünnfilm-Leuchtdiodenchip zeichnet sich bevorzugt durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat", dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

Das optoelektronische Bauteil umfasst einen Gehäusekörper, der an der Oberseite der Leiterplatte an der Leiterplatte befestigt ist. Beispielsweise kann der Gehäusekörper mittels eines Klebstoffs an der Oberseite der Leiterplatte an dieser befestigt sein. Ferner ist es möglich, dass der Gehäusekörper verbindungsmittelfrei an der Leiterplatte befestigt ist. Dazu kann der Gehäusekörper beispielsweise mittels eines Spritzgussverfahrens oder eines Spritzpressverfahrens an die Oberseite der Leiterplatte angespritzt oder angepresst sein. Eine mechanische Verbindung zwischen Gehäusekörper und Leiterplatte kann zum Beispiel beim Aushärten des Materials des Gehäusekörpers erfolgen.

Der Gehäusekörper weist einen Reflektorbereich auf. Der Reflektorbereich ist dazu vorgesehen, vom optoelektronischen Halbleiterchip im Betrieb erzeugte elektromagnetische Strahlung oder vom optoelektronischen Halbleiterchip im Betrieb zu detektierende elektromagnetische Strahlung zu reflektieren.

Der Reflektorbereich umfasst eine Öffnung im Gehäusekörper, in der der optoelektronische Halbleiterchip angeordnet ist. Die Öffnung erstreckt sich dabei vorzugsweise von der der Leiterplatte abgewandten Oberseite des Gehäusekörpers zu der der Leiterplatte zugewandten Unterseite des Gehäusekörpers. Das bedeutet, in der Öffnung liegt die Leiterplatte mit dem Chipanschlussbereich frei. Auf diese Weise umgibt der Gehäusekörper den optoelektronischen Halbleiterchip im Bereich der Öffnung zumindest stellenweise. Die dem optoelektronischen Halbleiterchip zugewandten Seitenflächen des Gehäusekörpers in der Öffnung bilden strahlungsreflektierende Flächen des Reflektorbereichs - also die Reflektorfläche - und können dazu beispielsweise geeignet beschichtet sein. Weist das Bauteil zwei oder mehr optoelektronische Halbleiterchips auf, so können in einer Öffnung zwei oder mehr optoelektronische Halbleiterchips angeordnet sein. Ferner ist es dann auch möglich, dass der Reflektorbereich zwei oder mehr Öffnungen umfasst und in jeder Öffnung genau ein optoelektronischer Halbleiterchip angeordnet ist.

Der optoelektronische Halbleiterchip ist in einen Verguss eingebettet, der weiß, schwarz oder farbig erscheint, wobei die dem Chipanschlussbereich abgewandte Oberfläche des optoelektronischen Halbleiterchips zumindest stellenweise frei vom Verguss ist. Insbesondere kann der Verguss die Farbe der Außenfläche des Gehäusekörpers haben.

Der Verguss kann strahlungsundurchlässig ausgebildet sein. Der Verguss ist zum Beispiel reflektierend ausgebildet. Der Verguss kann dazu zum Beispiel ein Matrixmaterial aus Silikon und/oder Epoxid umfassen, das mit reflektierenden Partikeln, zum Beispiel aus Titanoxid gefüllt ist.

Ferner ist es möglich, dass die Partikel aus ZrO₂ bestehen oder zumindest ZrO₂ enthalten. Emittiert der Halbleiterchip blaues oder ultraviolettes Licht weist ZrO₂ in einem derartigen Wellenlängenbereich besonders geringe Absorptionseigenschaften auf. Mit anderen Worten wird in diesem Fall ein hoher Anteil an elektromagnetischer Strahlung vom Verguss reflektiert.

Insgesamt ist es möglich, dass die strahlungsreflektierenden Partikel zumindest aus einem der Materialien TiO₂, BaSO₄, ZnO, AlₓO_{y}, ZrO₂ bestehen oder eines der genannten Materialien enthalten. Der Verguss erscheint dann zum Beispiel als weiß.

Weiter ist es möglich, dass der Verguss mit strahlungsabsorbierenden Partikeln, zum Beispiel aus Ruß, gefüllt ist, so dass der Verguss schwarz erscheint.

Beim optoelektronischen Halbleiterchip handelt es sich bevorzugt um einen Oberflächenemitter, der zum Beispiel als Dünnfilm-Leuchtdiodenchip ausgeführt ist. Das heißt, der optoelektronische Halbleiterchip ist dann insbesondere kein Volumenemitter. Das heißt, es tritt in diesem Fall kaum elektromagnetische Strahlung durch die Seitenflächen des Halbeiterchips aus.

Der Gehäusekörper ist mit einem Kunststoffmaterial gebildet. Bei dem Kunststoffmaterial handelt es sich vorzugsweise um ein thermisch besonders stabiles Kunststoffmaterial, das bevorzugt schmelzverarbeitbar ist. Beispielsweise ist der Gehäusekörper dazu mit einem Polyphenylsulfid (PPS) gebildet. Der Grundkörper der Leiterplatte kann dann mit dem gleichen Kunststoffmaterial oder mit einem Kunststoffmaterial mit ähnlichem thermischem Ausdehnungskoeffizienten gebildet sein.

Der Gehäusekörper ist im Reflektorbereich zumindest stellenweise metallisiert. Das heißt, Teile des Gehäusekörpers, beispielsweise in der Öffnung im Gehäusekörper, sind zumindest stellenweise von einer Metallschicht bedeckt. Beispielsweise kann eine Reflektorfläche des Reflektorbereichs durch die metallisierten Bereiche des Gehäusekörpers gebildet sein. Der Gehäusekörper ist dann beispielsweise lediglich in der Öffnung des Reflektorbereichs metallisiert, andere Teile des Gehäusekörpers sind frei von der Metallisierung. Es ist jedoch auch möglich, dass sämtliche freiliegenden Außenflächen des Gehäusekörpers metallisiert sind. Eine solche Ausführungsform des optoelektronischen Bauteils ist besonders einfach herstellbar.

Die Metallisierung des Gehäusekörpers kann beispielsweise mittels thermischen Verdampfens auf das Kunststoffmaterial des Gehäusekörpers aufgebracht werden. Das Metall, das dabei auf den Gehäusekörper aufgebracht wird, wird im Hinblick auf die vom optoelektronischen Halbleiterchip im Betrieb zu detektierende oder auszusendende elektromagnetische Strahlung ausgewählt. Beispielsweise eignet sich Gold für Infrarotstrahlung mit Wellenlängen von 800 nm und mehr. Eine Metallisierung mit Silber oder Aluminium eignet sich insbesondere für den sichtbaren Bereich. Das Metall der Metallisierung wird vorzugsweise direkt auf den Gehäusekörper aufgebracht. Bei der Verwendung von Metallen, die zur Korrosion und Diffusion neigen, wird auf die Metallisierung an ihrer dem Gehäusekörper abgewandten Seite eine Passivierungsschicht aufgebracht, die strahlungsdurchlässig und vorzugsweise für die zu reflektierende Strahlung transparent ausgebildet ist. Die Passivierungsschicht kann beispielsweise mit einem Siliziumoxid und/oder einem Siliziumnitrid gebildet sein.

Gemäß zumindest einer Ausführungsform des optoelektronischen Bauteils umfasst das Bauteil eine Leiterplatte, die eine Oberseite mit einem Chipanschlussbereich aufweist, einen optoelektronischen Halbleiterchip, der am Chipanschlussbereich befestigt ist, einen Gehäusekörper, der an der Oberseite der Leiterplatte an der Leiterplatte befestigt ist und einen Reflektorbereich aufweist, wobei der Reflektorbereich eine Öffnung im Gehäusekörper umfasst, in der der optoelektronische Halbleiterchip angeordnet ist und der Gehäusekörper mit einem Kunststoffmaterial gebildet ist, das im Reflektorbereich zumindest stellenweise metallisiert ist.

Dem hier beschriebenen optoelektronischen Bauteil liegen dabei unter anderem die folgenden Ideen zugrunde:
Die Verwendung einer dünnen Leiterplatte, beispielsweise einer bedruckten Leiterplatte, lässt Raum für einen relativ dicken Gehäusegrundkörper, ohne dass eine vorgebbare Gesamtdicke des optoelektronischen Bauteils überschritten wird. Damit kann der Reflektorbereich, der beispielsweise eine Öffnung im Gehäusegrundkörper umfasst, die diesen vollständig durchdringt, über den optoelektronischen Halbleiterchip besonders hoch ausgebildet werden, ohne dass sich die Bauhöhe des Bauteils insgesamt zu sehr erhöht. Dadurch sind besonders enge Abstrahlwinkel von höchstens 20° halber Abstrahlkegel bei dennoch kompakter Bauform ermöglicht.

Durch die Ausbildung des Reflektorbereichs ist auch die Problematik des so genannten "Crosstalks" benachbarter strahlungsemittierender optoelektronischer Bauteile gleicher Bauform reduziert, da die Strahlung benachbart zueinander angeordneter optoelektronischer Bauteile derart geführt wird, dass sie nicht auf die Halbleiterchips der benachbart angeordneten optoelektronischen Bauteile treffen kann und somit auch von diesen Bauteilen nicht absorbiert oder gestreut werden kann.

Die Verwendung eines Gehäusekörpers, der mit einem Kunststoffmaterial gebildet ist und durch ein Spritzpressverfahren oder ein Spritzgussverfahren herstellbar ist, erlaubt eine besonders einfache und passgenaue Herstellung des Reflektorbereichs. Der Reflektorbereich, insbesondere die Öffnung des Reflektorbereichs, kann dabei besonders klein ausgeführt werden, sodass die Fläche einer dem optoelektronischen Halbleiterchip zugewandten Reflektoröffnung in der Größenordnung des Flächeninhalts der Außenfläche des optoelektronischen Halbleiterchips liegt.

Die Leiterplatte weist an ihrer Oberseite einen Drahtanschlussbereich auf, der zum Chipanschlussbereich beabstandet ist. Das heißt, Drahtanschlussbereich und Chipanschlussbereich sind beide an der Oberseite der Leiterplatte angeordnet, beispielsweise mittels des Grundkörpers der Leiterplatte elektrisch voneinander isoliert und in einem Abstand zueinander an der Oberseite der Leiterplatte angeordnet. Der Gehäusekörper weist weiter einen Drahtbereich auf, der eine Öffnung im Gehäusekörper umfasst. Der Drahtbereich ist dabei zum Reflektorbereich beabstandet. Das heißt beispielsweise, dass Reflektorbereich und Drahtbereich nicht dieselbe Öffnung im Gehäusekörper umfassen, sondern dass im Gehäusekörper wenigstens zwei Öffnungen ausgebildet sind, die den Gehäusekörper vollständig durchdringen, wobei die erste Öffnung dem Reflektorbereich und die zweite Öffnung dem Drahtbereich zugeordnet ist. In der zweiten Öffnung, das heißt im Drahtbereich, ist dann der Drahtanschlussbereich der Leiterplatte angeordnet. Die Öffnung bildet also einen Durchbruch im Gehäusekörper, an dem zumindest der Drahtanschlussbereich an der Oberseite der Leiterplatte freiliegt.

Gemäß zumindest einer Ausführungsform des optoelektronischen Bauteils umfasst das optoelektronische Bauteil einen Anschlussdraht, der am optoelektronischen Halbleiterchip und am Drahtanschlussbereich befestigt ist. Über den Anschlussdraht ist der optoelektronische Halbleiterchip beispielsweise n-seitig elektrisch kontaktiert. Der Anschlussdraht ist dabei durch eine Ausnehmung im Gehäusekörper geführt, die den Reflektorbereich und den Drahtbereich miteinander verbindet. Beispielsweise ist die Ausnehmung als Tunnel oder Graben im Gehäusematerial ausgeführt, der sich vom Reflektorbereich zum Drahtbereich erstreckt. An einer Bodenfläche der Ausnehmung kann die Leiterplatte dabei stellenweise freiliegen. In diesem Fall ist die Ausnehmung beispielsweise ein Durchbruch im Gehäusekörper. Es ist aber auch möglich, dass der Gehäusekörper im Bereich der Ausnehmung nicht vollständig entfernt ist, sodass die Bodenfläche der Ausnehmung durch Material des Gehäusekörpers gebildet ist. In jedem Fall ist der Anschlussdraht derart durch die Ausnehmung zwischen Reflektorbereich und Drahtbereich geführt, dass der Anschlussdraht eine der Leiterplatte abgewandte Oberseite des Gehäusekörpers nicht überragt.

Gemäß zumindest einer Ausführungsform des optoelektronischen Bauteils bedeckt der Gehäusekörper die Leiterplatte abgesehen vom Reflektorbereich und, falls vorhanden, dem Drahtbereich und der Ausnehmung, an der Oberseite der Leiterplatte vollständig. Das heißt, die Oberseite der Leiterplatte ist vom Gehäusekörper abgedeckt und von außen bis auf die genannten Bereiche nicht zugänglich und/oder nicht einsehbar.

Gemäß zumindest einer Ausführungsform des Gehäusekörpers schließt zumindest eine Seitenfläche des Gehäusekörpers zumindest stellenweise bündig mit zumindest einer Seitenfläche der Leiterplatte ab. Beispielsweise ist es möglich, dass sämtliche Seitenflächen von Gehäusekörper und Leiterplatte bündig miteinander abschließen.

Gemäß zumindest einer Ausführungsform weist die Grundfläche des Gehäusekörpers die gleiche Form auf wie die Grundfläche der Leiterplatte und/oder die Grundfläche des Gehäusekörpers weist die gleiche Größe wie die Grundfläche der Leiterplatte auf. Ist die Leiterplatte beispielsweise rechteckig oder quadratisch ausgebildet, so ist der Gehäusekörper ein Quader.

Die Seitenflächen von Leiterplatte und Gehäusekörper können dann bündig miteinander abschließen. Insgesamt weist das optoelektronische Bauteil dann die Form eines Quaders auf, bei dem die Unterseite durch die Leiterplatte gebildet ist. An der der Unterseite abgewandten Oberseite des Quaders befindet sich die zumindest eine Öffnung im Reflektorbereich.

Gemäß zumindest einer Ausführungsform des optoelektronischen Bauteils umfasst der Reflektorbereich eine chipnahe Reflektoröffnung und eine chipferne Reflektoröffnung. Dabei verjüngt sich zum Beispiel die dem Reflektorbereich zugeordnete Öffnung von der chipfernen Reflektoröffnung zur chipnahen Reflektoröffnung. Das heißt insbesondere, dass die chipferne Reflektoröffnung einen größeren Flächeninhalt als die chipnahe Reflektoröffnung aufweist. Zumindest eine Reflektorfläche des Reflektorbereichs verbindet die chipnahe Reflektoröffnung und die chipferne Reflektoröffnung miteinander. Die Reflektorfläche ist beispielsweise durch den metallisierten Gehäusekörper des optoelektronischen Bauteils innerhalb der Öffnung gebildet. Das heißt, die Reflektorfläche ist durch einen Teil des Gehäusekörpers gebildet, der zumindest stellenweise metallisiert ist. Dabei ist es insbesondere möglich, dass der Gehäusekörper lediglich im Bereich der Reflektorfläche metallisiert ist, sodass besonders wenig Metall zur Bildung der Metallisierung benötigt wird.

Gemäß zumindest einer Ausführungsform des optoelektronischen Bauteils weist die chipnahe Reflektoröffnung einen Flächeninhalt auf, der höchstens vier Mal so groß ist wie der Flächeninhalt der Hauptfläche des optoelektronischen Halbleiterchips, die der Leiterplatte abgewandt ist. Beispielsweise handelt es sich bei der Hauptfläche des Halbleiterchips um dessen Deckfläche. Eine Strahlungsemission bei einem strahlungsemittierenden optoelektronischen Halbleiterchip kann dann beispielsweise größtenteils durch diese Hauptfläche erfolgen. Eine solche besonders kleine chipnahe Reflektoröffnung kann dadurch erreicht sein, dass der Drahtanschlussbereich des optoelektronischen Bauteils beabstandet zum Chipanschlussbereich angeordnet ist und damit der Drahtbereich des Gehäusekörpers beabstandet zur Reflektoröffnung angeordnet werden kann. Auf diese Weise kann die Reflektoröffnung besonders klein gewählt werden und muss nur hinsichtlich ihrer optischen Eigenschaften dimensioniert werden.

Gemäß zumindest einer Ausführungsform des optoelektronischen Bauteils weist die Leiterplatte eine der Oberseite abgewandte Unterseite auf, wobei an der Unterseite der Leiterplatte Bauteilanschlussbereiche ausgebildet sind. Über diese Bauteilanschlussbereiche ist das optoelektronische Bauteil oberflächenmontierbar.

Gemäß zumindest einer Ausführungsform des optoelektronischen Bauteils weist das optoelektronische Bauteil eine Dicke von höchstens 1 mm auf, wobei die Leiterplatte eine Dicke von höchstens 0,35 mm und der Gehäusekörper eine Dicke von höchstens 0,65 mm aufweist. Eine solch geringe Dicke des optoelektronischen Bauteils ist insbesondere durch die Verwendung einer Leiterplatte mit einem Grundkörper aus Kunststoff und einem Gehäusekörper, der mittels eines Spritzgussverfahrens oder eines Spritzpressverfahrens erzeugt werden kann, ermöglicht. Die Verwendung einer Leiterplatte mit einem Grundkörper aus Kunststoff ermöglicht eine besonders dünne Leiterplatte. Die genannten Herstellungsverfahren erlauben eine besonders passgenaue Herstellung des Gehäusekörpers und insbesondere des Reflektorbereichs.

Im Folgenden wird das hier beschriebene optoelektronische Bauteil anhand von Ausführungsbeispielen und den dazugehörigen Figuren näher erläutert.
Die Figuren 1A, 1B, 1C, 1D, 1E und 1F zeigen dabei unterschiedliche schematische Ansichten eines Beispiels eines hier beschriebenen optoelektronischen Bauteils.
Die Figur 1G zeigt ein Ausführungsbeispiel eines hier beschriebenen optoelektronischen Bauteils.
Die Figur 2 zeigt eine graphische Auftragung der relativen Intensität E der vom Bauteil im Betrieb abgestrahlten elektromagnetischen Strahlung in Abhängigkeit Abstrahlhalbwinkels a.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

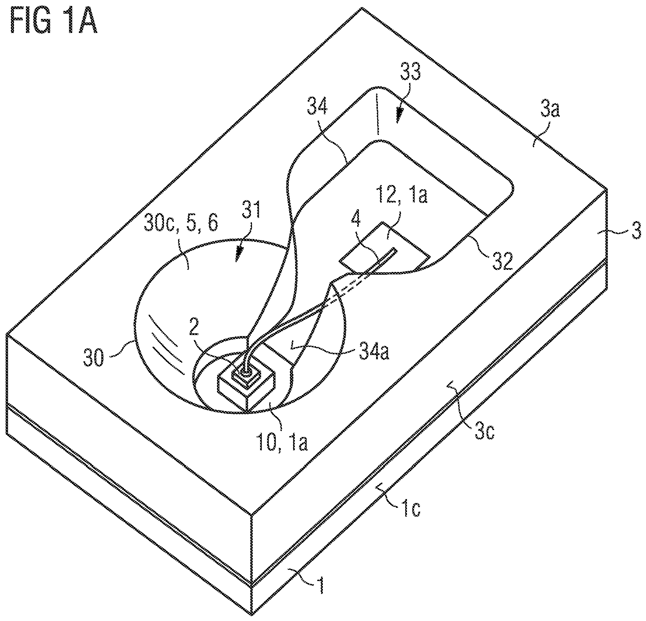

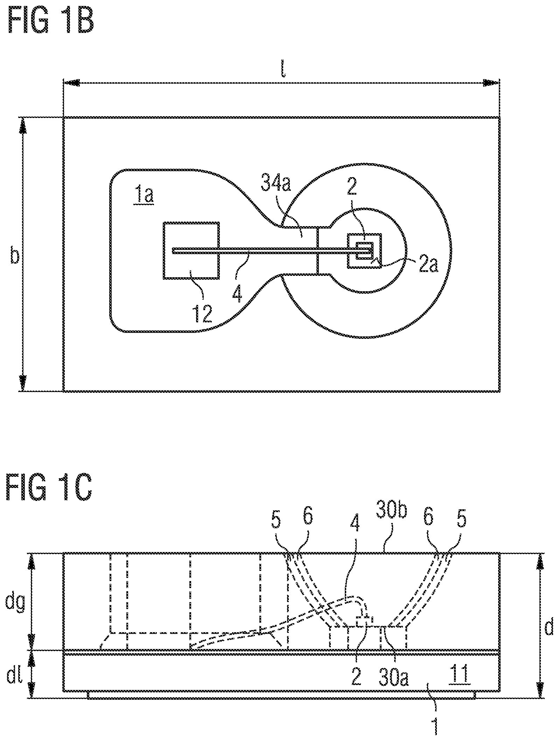

Die Figur 1A zeigt eine schematische Perspektivdarstellung eines Beispiels eines hier beschriebenen optoelektronischen Bauteils. Das optoelektronische Bauteil umfasst eine Leiterplatte 1, die vorliegend beispielsweise einen Grundkörper 11 (vergleiche dazu beispielsweise Figur 1C) aufweist, der aus einem Kunststoff besteht. An der Oberseite 1a der Leiterplatte 1 ist ein Gehäusekörper 3 angeordnet. Die Seitenflächen 1c der Leiterplatte 1 und die Seitenflächen 3c des Gehäusekörpers 3 schließen jeweils bündig miteinander ab.

Leiterplatte 1 und Gehäusekörper 3 weisen eine rechteckige Grundfläche gleicher Form und Größe auf. Insgesamt weist das optoelektronische Bauteil eine Quaderform auf, wobei die Unterseite des Quaders durch die Leiterplatte 1 gebildet ist.

An der Oberseite 3a des Gehäusekörpers 3 sind zur Leiterplatte 1 hin zwei Öffnungen 31, 33 und eine Ausnehmung 34 ausgebildet.

Der Reflektorbereich 30 umfasst die erste Öffnung 31. Die erste Öffnung 31 erstreckt sich von der Oberseite 3a des Gehäusekörpers 3 zur Oberseite 1a der Leiterplatte 1, sodass die Oberseite 1a der Leiterplatte 1 im Bereich der Öffnung 31 stellenweise freiliegt. Die Leiterplatte 1 umfasst dort den Chipanschlussbereich 10. Am Chipanschlussbereich 10 ist ein optoelektronischer Halbleiterchip 2, beispielsweise ein Leuchtdiodenchip, befestigt und elektrisch angeschlossen.

Um den optoelektronischen Halbleiterchip 2 herum erstreckt sich die Reflektorfläche 30c. Die Reflektorfläche ist beispielsweise durch den Gehäusekörper 3 im Bereich der Öffnung 31 gebildet, der dort zumindest mit einer Metallschicht 5 (vergleiche dazu beispielsweise die Schnittdarstellung der Figur 1C) beschichtet ist. Falls notwendig, kann die dem Gehäusekörper 3 abgewandte Seite der Metallschicht 5 mit einer Passivierungsschicht 6 bedeckt sein, die strahlungsdurchlässig, vorzugsweise transparent, ausgebildet ist.

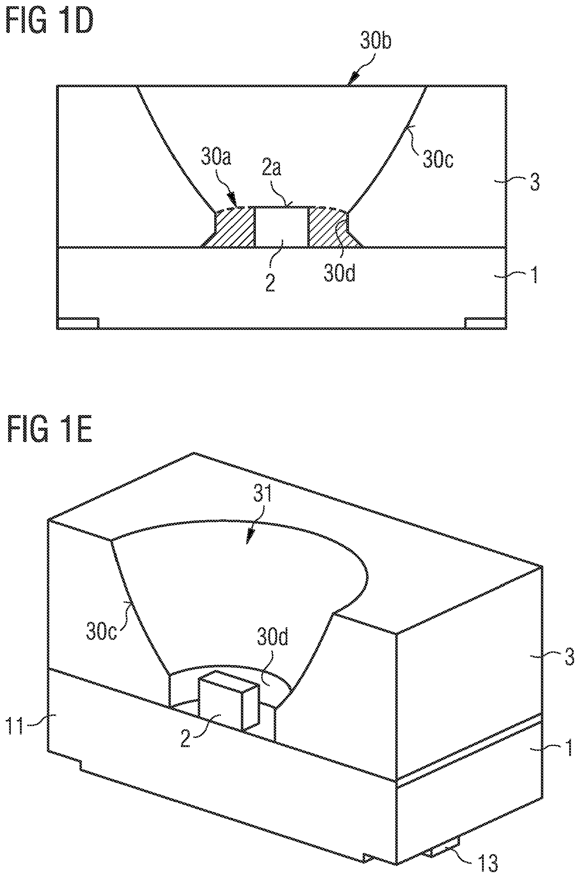

An die Reflektorfläche 30c, die schräg zur Oberseite 1a der Leiterplatte 1 verläuft, kann sich ein Ring 30d anschließen, der senkrecht oder im Wesentlichen senkrecht zur Leiterplatte 1 an ihrer Oberseite 1a verläuft (vergleiche dazu die schematische, perspektivische Schnittdarstellung der Figur 1E). Im Bereich dieses Rings kann der Grundkörper 3 frei von der Metallschicht 5 sein. Beispielsweise ist es möglich, dass zur Einstellung der Abstrahlcharakteristik der Grundkörper 3 in diesem Bereich strahlungsabsorbierend für vom optoelektronischen Halbleiterchip im Betrieb erzeugte elektromagnetische Strahlung ausgebildet ist. Es ist aber auch möglich, dass auch im Bereich des Rings die Metallschicht 5 auf den Grundkörper 3 aufgebracht ist. Der Ring 30d weist eine Höhe auf, die maximal der Höhe des optoelektronischen Halbleiterchips entspricht.

Der Gehäusekörper 3 weist eine zweite Öffnung 33 auf, die vom Drahtbereich 32 umfasst ist. In der Öffnung 33 liegt die Oberseite 1a der Leiterplatte 1 mit dem Drahtanschlussbereich 12 frei.

Ein Anschlussdraht 4 ist zur elektrischen Kontaktierung des optoelektronischen Halbleiterchips 2 vom optoelektronischen Halbleiterchip 2 zum Drahtanschlussbereich 12 geführt und am optoelektronischen Halbleiterchip 2 und am Drahtanschlussbereich 12 befestigt.

Der Anschlussdraht 4 ist dabei durch die Ausnehmung 34 geführt, in der die Reflektorfläche 30c stellenweise durchbrochen ist. An der Bodenfläche 34a (vergleiche die schematische Draufsicht der Figur 1B) der Ausnehmung 34 kann die Oberseite 1a der Leiterplatte 1 freiliegen. Dabei ist es möglich, dass die Leiterplatte 1 an ihrer Oberseite 1a im Drahtbereich 32 und im Bereich der Bodenfläche 34a der Ausnehmung 34 strahlungsabsorbierend, zum Beispiel schwarz, ausgebildet ist, um störende Reflexionen in diesen Bereichen zu vermeiden. Dahingegen kann die Leiterplatte 1 an ihrer Oberseite 1a im Reflektorbereich 30 reflektierend beschichtet sein. Beispielsweise kann dort ein mit Titanoxid gefüllter Silikonverguss eingebracht sein, der auch den Ring 30d bedecken kann.

Die Öffnung 31, die vom Reflektorbereich 30 umfasst ist, kann mit einem strahlungsdurchlässigen Vergussmaterial befüllt sein, das bis zur Oberseite 3a des Grundkörpers 3 reicht oder diesen überragt. Die Öffnung 33, die vom Drahtbereich 32 umfasst ist, und die Ausnehmung 34 können mit einem Vergussmaterial bedeckt sein, das beispielsweise die gleiche Farbe wie der Grundkörper 3 an seiner Oberseite 3a aufweist, sodass der Drahtbereich 32 von außen nicht zu erkennen ist. Ferner ist es möglich, dass der Verguss schwarz ausgebildet ist und damit geeignet ist zum Beispiel Streulicht zu absorbieren.

Die Figur 1B zeigt eine schematische Draufsicht auf das Beispiel des optoelektronischen Bauteils. Die Breite b des optoelektronischen Bauteils beträgt vorzugsweise höchstens 2 mm, zum Beispiel 1,7 mm. Die Länge des optoelektronischen Bauteils 1 beträgt vorzugsweise höchstens 3 mm, beispielsweise 2,75 mm.

Die Figur 1C zeigt eine schematische Schnittdarstellung des Beispiels des optoelektronischen Bauteils. Die Gesamtdicke des optoelektronischen Bauteils d beträgt vorzugsweise höchstens 1 mm, zum Beispiel 0,9 mm. Die Dicke der Leiterplatte 1 dl beträgt vorzugsweise höchstens 40 mm, zum Beispiel 0,3 mm, und die Dicke des Grundkörpers 3 dg beträgt vorzugsweise höchstens 0,65 mm, zum Beispiel 0,6 mm. Insgesamt ist auf diese Weise ein besonders kompaktes optoelektronisches Bauteil realisiert, bei dem aufgrund der geringen Dicke der Leiterplatte 1 der Reflektor im Reflektorbereich 30 relativ hoch, nämlich wenigstens 0,6 mm hoch, ausgebildet werden kann.

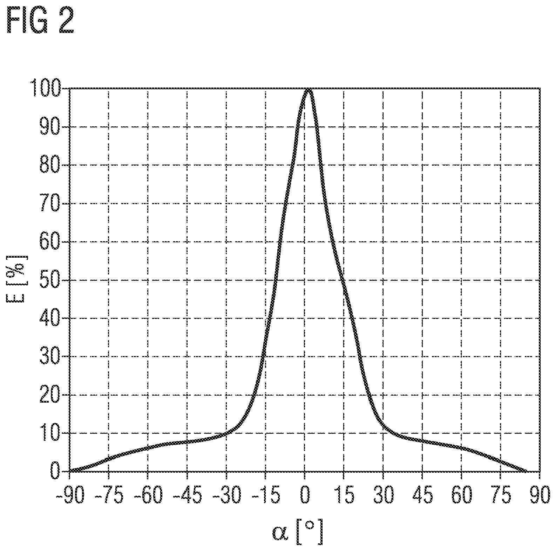

Die schematische Schnittdarstellung der Figur 1D zeigt, dass der Flächeninhalt der Hauptfläche 2a des optoelektronischen Halbleiterchips 2 in der Größenordnung der chipnahen Reflektoröffnung 30a liegt. In Verbindung mit der relativ großen Höhe des Reflektors ist es möglich, einen Abstrahlhalbwinkel α von höchstens 20°, zum Beispiel 13°, zu erreichen (vergleich dazu die graphische Auftragung der Figur 2). Die Abstrahlintensität bei der Verwendung eines strahlungsemittierenden optoelektronischen Halbleiterchips kann dann beispielsweise 80 mW pro Steradiant (sr) bei einer Bestromung mit 70mA betragen.

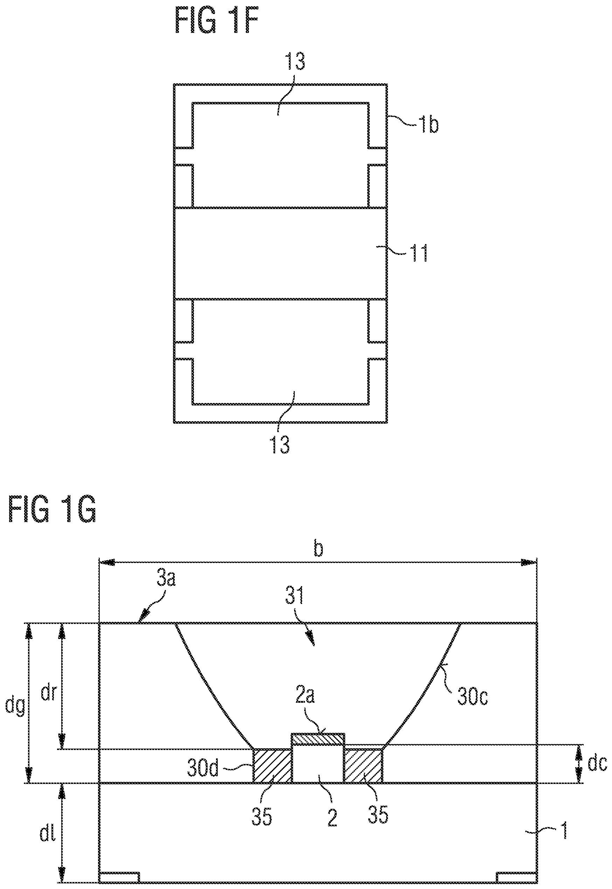

In Verbindung mit der Draufsicht auf die Unterseite 1b der Leiterplatte 1 der Figur 1F ist zu erkennen, dass an der Unterseite 1b der Leiterplatte 1 Bauteilanschlussbereiche 13 angeordnet sind, die mit dem Chipanschlussbereich 10 beziehungsweise dem Drahtanschlussbereich 12 elektrisch leitend verbunden sind und zur Oberflächenmontage des optoelektronischen Bauteils dienen.

Die Figur 1G zeigt eine schematische Schnittdarstellung eines Ausführungsbeispiels des optoelektronischen Bauteils. Aus der Figur 1G ist ersichtlich, dass der optoelektronische Halbleiterchip 2 eine Höhe dc von höchsten 0,20 mm, zum Beispiel 0,15 mm aufweist. Die Höhe dr der Reflektorfläche 30c betragt zum Beispiel wenigstens 0,4 mm, zum Beispiel 0,47 mm. Der Durchmesser der ersten Öffnung 31 an der Oberseite 3a des Gehäusekörpers 3 beträgt zum Beispiel wenigstens 0,6 mm und höchstens 1,1 mm, zum Beispiel 1 mm.

In der Figur 1G ist ferner dargestellt, dass der optoelektronische Halbleiterchip 2 im Bereich des Rings 30d von einem Verguss 35 umgeben sein kann. Der Verguss 35 kann dabei bis zur Oberseite des Halbeiterchips 2 reichen und bündig mit dem Halbeiterchip 2 an dessen Oberseite abschließen.

Der Verguss 35 kann strahlungsundurchlässig ausgebildet sein. Der Verguss ist zum Beispiel reflektierend ausgebildet. Der Verguss 35 kann dazu zum Beispiel ein Matrixmaterial aus Silikon und/oder Epoxid umfassen, das mit reflektierenden Partikeln, zum Beispiel aus Titanoxid gefüllt ist. Der Verguss erscheint dann als weiß.

Ferner ist es möglich, dass die Partikel aus ZrO₂ bestehen oder zumindest ZrO₂ enthalten. Emittiert der Halbleiterchip 2 blaues oder ultraviolettes Licht weist ZrO₂ in einem derartigen Wellenlängenbereich besonders geringe Absorptionseigenschaften auf. Mit anderen Worten wird in diesem Fall ein hoher Anteil an elektromagnetischer Strahlung vom Verguss reflektiert.

Insgesamt ist es möglich, dass die strahlungsreflektierenden Partikel zumindest aus einem der Materialien TiO₂, BaSO₄, ZnO, AlₓO_{y}, ZrO₂ bestehen oder eines der genannten Materialien enthalten.

Weiter ist es möglich, dass der Verguss 35 mit strahlungsabsorbierenden Partikeln, zum Beispiel aus Ruß, gefüllt ist, so dass der Verguss 35 schwarz erscheint. Beim optoelektronischen Halbleiterchip 2 handelt es sich bevorzugt um einen Oberflächenemitter, der zum Beispiel als Dünnfilm-Leuchtdiodenchip ausgeführt ist. Das heißt, der optoelektronische Halbleiterchip 2 ist dann insbesondere kein Volumenemitter.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist. Diese Patentanmeldung beansprucht die Priorität der deutschen Patentanmeldung 102010023955.0.

## Patentansprüche

1. Optoelektronisches Bauteil mit
- einer Leiterplatte (1), die eine Oberseite (1a) mit einem Chipanschlussbereich (10) aufweist, und bei der es sich um eine bedruckte Leiterplatte handelt,
- einem optoelektronischen Halbleiterchip (2), der am Chipanschlussbereich (10) befestigt ist,
- einem Gehäusekörper (3), der an der Oberseite (1a) der Leiterplatte (1) an der Leiterplatte (1) befestigt ist und einen Reflektorbereich (30) aufweist, wobei
- der Reflektorbereich (30) eine Öffnung (31) im Gehäusekörper (3) umfasst, in der der optoelektronische Halbleiterchip (2) angeordnet ist, wobei
- die Leiterplatte (1) an ihrer Oberseite (1a) einen Drahtanschlussbereich (12) aufweist, der zum Chipanschlussbereich (10) beabstandet ist, und
- der Gehäusekörper (3) einen Drahtbereich (32) aufweist, der eine Öffnung (33) im Gehäusekörper (3) umfasst, in der der Drahtanschlussbereich (32) angeordnet ist, wobei
- der Drahtbereich (32) zum Reflektorbereich (30) beabstandet ist, und das optoelektronische Bauteil **dadurch gekennzeichnet ist, dass**
- der Gehäusekörper (3) mit einem Kunststoffmaterial gebildet ist, das im Reflektorbereich (30) zumindest stellenweise metallisiert ist,
- der optoelektronischen Halbleiterchip (2) in einen Verguss (35) eingebettet ist, der weiß, schwarz oder farbig erscheint, wobei die dem Chipanschlussbereich (10) abgewandte Oberfläche des optoelektronischen Halbleiterchips (2) frei vom Verguss (35) ist.

2. Optoelektronisches Bauteil nach dem vorherigen Anspruch, bei dem die Leiterplatte (1) einen Grundkörper (11) aufweist, der mit einem Kunststoffmaterial gebildet ist, wobei der Grundkörper (11) der Leiterplatte (1) mit dem gleichen Kunststoff wie der Gehäusekörper (3) gebildet ist.

3. Optoelektronisches Bauteil nach Anspruch 1 mit
- einem Anschlussdraht (4), der am optoelektronischen Halbleiterchip (2) und am Drahtanschlussbereich (12) befestigt ist, wobei
- der Anschlussdraht (4) durch eine Ausnehmung (34) im Gehäusekörper (3) geführt ist, die den Reflektorbereich (30) und den Drahtbereich (32) miteinander verbindet.

4. Optoelektronisches Bauteil nach dem vorherigen Anspruch, bei dem an einer Bodenfläche (34a) der Ausnehmung die Leiterplatte (1) stellenweise freiliegt.

5. Optoelektronisches Bauteil nach einem der vorherigen Ansprüche,
bei dem der Gehäusekörper (3) die Leiterplatte (1) bis auf den Reflektorbereich (30) und gegebenenfalls den Drahtbereich (32) und die Ausnehmung (34) an der Oberseite (1a) der Leiterplatte (1) vollständig abdeckt.

6. Optoelektronisches Bauteil nach einem der vorherigen Ansprüche,
bei dem der Gehäusekörper (3) an Seitenflächen (3c) zumindest stellenweise bündig mit Seitenflächen (1c) der Leiterplatte (1) abschließt.

7. Optoelektronisches Bauteil nach einem der vorherigen Ansprüche,
bei dem eine Grundfläche des Gehäusekörpers (3) die gleiche Form wie eine Grundfläche der Leiterplatte (1) aufweist.

8. Optoelektronisches Bauteil nach einem der vorherigen Ansprüche,
bei dem eine Grundfläche des Gehäusekörpers (3) die gleiche Größe wie eine Grundfläche der Leiterplatte (1) aufweist.

9. Optoelektronisches Bauteil nach einem der vorherigen Ansprüche,
bei dem
- der Reflektorbereich (30) eine chipnahe Reflektoröffnung (30a) und eine chipferne Reflektoröffnung (30b) umfasst,
- die Öffnung (31) des Reflektorbereichs (30) sich von der chipfernen Reflektoröffnung (30b) zur chipnahen Reflektoröffnung (30a) verjüngt, und
- zumindest eine Reflektorfläche (30c) des Reflektorbereichs die chipnahe Reflektoröffnung (30a) und die chipferne Reflektoröffnung (30b) miteinander verbindet, wobei
- die Reflektorfläche (30c) durch einen Teil des Gehäusekörpers (3) gebildet ist, der zumindest stellenweise metallisiert ist.

10. Optoelektronisches Bauteil nach dem vorherigen Anspruch,
bei dem der Gehäusekörper (3) lediglich im Bereich der Reflektorfläche (30c) metallisiert ist.

11. Optoelektronisches Bauteil nach einem der vorherigen Ansprüche,
bei dem die chipnahe Reflektoröffnung (30a) einen Flächeninhalt aufweist, der höchstens viermal so groß ist wie der Flächeninhalt einer Hauptfläche (2a) des optoelektronischen Halbleiterchips (2).

12. Optoelektronisches Bauteil nach einem der vorherigen Ansprüche,
bei dem die Leiterplatte (1) eine der Oberseite (1a) abgewandte Unterseite (1b) aufweist, wobei an der Unterseite (1b) Bauteilanschlussbereiche (13) zu einer Oberflächenmontage ausgebildet sind.

13. Optoelektronisches Bauteil nach einem der vorherigen Ansprüche, mit einer Dicke (d) von höchstens 1,0 mm, wobei die Leiterplatte (1) eine Dicke (dl) von höchstens 0,35 mm und der Gehäusekörper (3) eine Dicke (dg) von höchsten 0,65 mm aufweist.

## Claims

1. An optoelectronic device having
- a circuit board (1) having an upper side (1a) with a chip connection region (10), and wherein the circuit board (1) is a printed circuit board,
- an optoelectronic semiconductor chip (2) which is attached to the chip connection region (10),
- a housing body (3) which is attached to the circuit board (1) on the upper side (1a) of the circuit board (1) and has a reflector region (30), wherein
- the reflector region (30) comprises an opening (31) in the housing body (3), in which opening (31) the optoelectronic semiconductor chip (2) is arranged,
wherein
- the circuit board (1), on its upper side (1a), has a wire connection region (12) which is spaced from the chip connection region (10), and
- the housing body (3) has a wire region (32) comprising an opening (33) in the housing body (3), in which opening (33) the wire connection region (32) is arranged, wherein
- the wire region (32) is spaced from the reflector region (30), and the optoelectronic device is **characterized in that**
- the housing body (3) is formed with a plastic material which is metallized, at least in places, in the reflector region (30),
- the optoelectronic semiconductor chip (2) is embedded into a potting (35) which appears white, black or colored, wherein the surface of the optoelectronic semiconductor chip (2), facing away from the chip connection region (10), is free of potting (35).

2. An optoelectronic device according to the preceding claim,
wherein the circuit board (1) has a base body (11) which is formed with a plastic material, wherein the base body (11) of the circuit board (1) is formed with the same plastic as the housing body (3).

3. An optoelectronic device according to claim 1 having
- a connection wire (4) which is attached to the optoelectronic semiconductor chip (2) and to the wire connection region (12), wherein
- the connection wire (4) is guided through a recess (34) in the housing body (3), which recess (34) interconnects the reflector region (30) and the wire region (32).

4. An optoelectronic device according to the preceding claim,
wherein, on a bottom surface (34a) of the recess, the circuit board (1) is exposed in places.

5. An optoelectronic device according to any of the preceding claims,
wherein the housing body (3) completely covers the circuit board (1), except for the reflector region (30), and optionally the wire region (32) and the recess (34) on the upper side (1a) of the circuit board (1).

6. An optoelectronic device according to any of the preceding claims,
wherein, on side surfaces (3c), the housing body (3) is, at least in places, flush with side surfaces (1c) of the circuit board (1).

7. An optoelectronic device according to any of the preceding claims,
wherein a base area of the housing body (3) has the same form as a base area of the circuit board (1).

8. An optoelectronic device according to any of the preceding claims,
wherein a base area of the housing body (3) has the same size as a base area of the circuit board (1).

9. An optoelectronic device according to any of the preceding claims,
wherein
- the reflector region (30) comprises a chip-near reflector opening (30a) and a chip-distant reflector opening (30b),
- the opening (31) of the reflector region (30) tapers from the chip-distant reflector opening (30b) to the chip-near reflector opening (30a), and
- at least one reflector surface (30c) of the reflector region interconnects the chip-near reflector opening (30a) and the chip-distant reflector opening (30b),
wherein
- the reflector area (30c) is formed by a part of the housing body (3) which is metallized, at least in places.

10. An optoelectronic device according to the preceding claim,
wherein the housing body (3) is metallized only in the region of the reflector area (30c).

11. An optoelectronic device according to any of the preceding claims,
wherein the chip-near reflector opening (30a) has a surface area which is at most four times as large as the surface area of a main surface (2a) of the optoelectronic semiconductor chip (2).

12. An optoelectronic device according to any of the preceding claims,
wherein the circuit board (1) has an underside (1b) facing away from the upper side (1a), wherein, on the underside (1b), device connection regions (13) are designed for surface mounting.

13. An optoelectronic device according to any of the preceding claims, having a thickness (d) of at most 1.0 mm, wherein the circuit board (1) has a thickness (dl) of at most 0.35 mm, and the housing body (3) has a thickness (dg) of at most 0.65 mm.

## Revendications

1. Composant optoélectronique comprenant
- une carte de circuit (1), ayant un côté supérieur (1a) avec une région de connexion de puce (10), et dans lequel il s'agit d'une carte de circuit imprimé,
- une puce optoélectronique à semi-conducteur (2), qui est fixée à la région de connexion de puce (10),
- un corps de boîtier (3) qui, à la face supérieure (1a) de la carte de circuit (1), est fixée à la carte de circuit (1) et présente une région de réflecteur (30), la région de réflecteur (30) comprenant une ouverture (31) dans le corps de boîtier (3), dans laquelle la puce optoélectronique à semi-conducteur (2) est agencée, dans lequel
- la carte de circuit (1) à sa face supérieure (1a) présente une région de connexion de fil (12) qui est espacée de la région de connexion de puce (10), et
- le corps de boîtier (3) présente une région de fil (32) comprenant une ouverture (33) dans le corps de boîtier (3), dans laquelle la région de connexion de fil (32) est agencée, dans lequel
- la région de fil (32) est espacée de la région de réflecteur (30), et le composant optoélectronique est **caractérisé en ce que**
- le corps de boîtier (3) est formé avec un matériau plastique qui est métallisé au moins par endroits dans la région de réflecteur (30),
- la puce optoélectronique à semi-conducteur (2) est intégrée dans un blindage (35), apparaissant blanc, noir ou coloré, dans lequel la surface la puce optoélectronique à semi-conducteur (2) détournée de la région de connexion de puce (10) est libre du blindage (35).

2. Composant optoélectronique selon la revendication précédente,
dans lequel la carte de circuit (1) présente un corps de base (11) qui est formé avec un matériau plastique, le corps de base (11) de la carte de circuit (1) étant formé avec le même matériau plastique que celui du corps de boîtier (3).

3. Composant optoélectronique selon la revendication 1, comportant
- un fil de connexion (4), qui est fixé à la puce optoélectronique à semi-conducteur (2) et à la région de connexion de fil (12), dans lequel
- le fil de connexion (4) est guidé à travers un évidement (34) dans le corps de boîtier (3) qui relie la région de réflecteur (30) et la région de fil (32).

4. Composant optoélectronique selon la revendication précédente,
dans lequel, au niveau d'une surface inférieure (34a) de l'évidement, la carte de circuit (1) est exposée par endroits.

5. Composant optoélectronique selon l'une quelconque des revendications précédentes,
dans lequel le corps de boîtier (3) couvre complètement la carte de circuit (1) à l'exception de la région de réflecteur (30) et éventuellement de la région de fil (32) et de l'évidement (34) à la face supérieure (1a) de la carte de circuit (1).

6. Composant optoélectronique selon l'une quelconque des revendications précédentes,
dans lequel le corps de boîtier (3) repose sur des surfaces latérales (3c) au moins par endroits en affleurement avec les surfaces latérales (1c) de la carte de circuit (1).

7. Composant optoélectronique selon l'une quelconque des revendications précédentes,
dans lequel une surface de base du corps de boîtier (3) a la même forme qu'une surface de base de la carte de circuit (1).

8. Composant optoélectronique selon l'une quelconque des revendications précédentes,
dans lequel une surface de base du corps de boîtier (3) a la même taille qu'une surface de base de la carte de circuit (1).

9. Composant optoélectronique selon l'une quelconque des revendications précédentes,
dans lequel
- la région de réflecteur (30) comprend une ouverture de réflecteur proche de la puce (30a) et une ouverture de réflecteur distante de la puce (30b),
- l'ouverture (31) de la région de réflecteur (30) se rétrécit de l'ouverture de réflecteur distante de la puce (30b) à l'ouverture de réflecteur proche de la puce (30a), et
- au moins une surface de réflecteur (30c) de la région de réflecteur relie l'ouverture de réflecteur proche de la puce (30a) et l'ouverture de réflecteur distante de puce (30b) l'une à l'autre, dans lequel
- la surface de réflecteur (30c) est formée par une partie du corps de boîtier (3) qui est métallisée au moins par endroits.

10. Composant optoélectronique selon la revendication précédente,
dans lequel le corps de boîtier (3) est métallisé uniquement dans la région de la surface de réflecteur (30c).

11. Composant optoélectronique selon l'une quelconque des revendications précédentes,
dans lequel l'ouverture de réflecteur proche de la puce (30a) présente une superficie étant au plus quatre fois supérieure à la superficie d'une surface principale (2a) de la puce optoélectronique à semi-conducteur (2).

12. Composant optoélectronique selon l'une quelconque des revendications précédentes,
dans lequel la carte de circuit (1) présente une face inférieure (1b) opposée à la face supérieure (1a), dans lequel à la face inférieure (1b), des régions de connexion de composants (13) sont conçues pour un montage en surface.

13. Composant optoélectronique selon l'une des revendications précédentes, d'une épaisseur (d) d'au plus 1,0 mm, dans lequel la carte de circuit (1) présente une épaisseur (dl) d'au plus 0,35 mm, et le corps de boîtier (3) présente une épaisseur (dg) d'au plus 0,65 mm.
